# EUROPEAN PATENT SPECIFICATION

(11) **EP 3 309 566 B1**
(45) Date of publication and mention of the grant of the patent: **21.07.2021**
(21) Application number: 16806717.1
(22) Date of filing: 24.05.2016
(51) Int. Cl.: G01R 31/50, H04B 10/07, H04J 14/02

(54) **METHOD AND DEVICE FOR PROCESSING REMOTE POWER FEED LINE DETECTION**
VERFAHREN UND VORRICHTUNG FÜR DIE LEITUNGSDETEKTION FÜR EINE ABGESETZTE STROMVERSORGUNG
PROCÉDÉ ET APPAREIL DE TRAITEMENT DE DÉTECTION DE LIGNE DE RETOUR DE PUISSANCE

(30) Priority: 09.06.2015 CN 201510312844
(43) Date of publication of application: 18.04.2018
(73) Proprietor: ZTE Corporation, Shenzhen, Guangdong 518057 (CN)
(72) Inventor: LU, Liuming, Shenzhen Guangdong 518057 (CN); YUAN, Liquan, Shenzhen Guangdong 518057 (CN); ZHANG, Weiliang, Shenzhen Guangdong 518057 (CN)
(74) Representative: Novagraaf Technologies
(86) International application number: PCT/CN2016/083186
(87) International publication number: WO 2016/197819

(56) References cited:
- WO-A1-2015/033091
- CN-A- 103 221 832
- CN-A- 103 403 563
- CN-A- 104 639 338
- FRANK VAN DER PUTTEN ALCATEL-LUCENT INTERNATIONAL FRANCE: "Report of the Q4/15 meeting (Geneva, June - July 2015);TD 522 (WP 1/15)", ITU-T DRAFT ; STUDY PERIOD 2013-2016, INTERNATIONAL TELECOMMUNICATION UNION, GENEVA ; CH, vol. 4/15, 2 July 2015 (2015-07-02), pages 1-14, XP044136320, [retrieved on 2015-07-02]
- LES BROWN HUAWEI CHINA: "Draft Recommendation ITU-T G.9701 (for Consent, 6 December 2013);TD 159 Rev.1 (PLEN/15)", ITU-T DRAFT ; STUDY PERIOD 2013-2016, INTERNATIONAL TELECOMMUNICATION UNION, GENEVA ; CH, vol. 4/15, 16 December 2013 (2013-12-16), pages 1-288, XP044120758, [retrieved on 2013-12-16]

## Description

### Technical Field

The present invention relates to, but is not limited to, the field of communications.

### Background

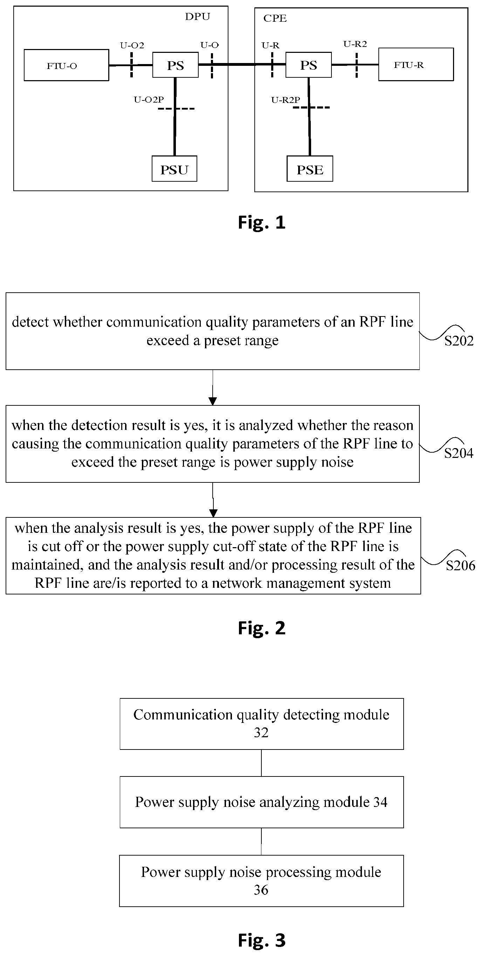

Fiber to the Distribution Point (FTTdp) is an important application scenario of a copper cable access system. As shown in Fig. 1, the upper part of a Distribution Point Unit (DPU) is connected to a fiber access system, and the lower part is connected to a piece of Customer Premise Equipment (CPE) via the copper cable access system. The fiber access system includes a Passive Optical Network (PON) system and a Point to Point (P2P) fiber system; the copper cable access system includes a Fast Access to Subscriber Terminal (FAST) system and a Very High Digital Subscriber Line 2 (VDSL2) system. The power supply environment is limited in the FTTdp application scenario, and the local power supply is very difficult, so Remote Power Feed (RPF) is a function that the copper cable access system must support. A piece of Power Supply Equipment (PSE) of a user side is used for supplying power for the DPU, and the PSE is either integrated with the CPE on a piece of equipment, or a piece of independent equipment. There may be multiple subscriber lines on the lower part of the DPU, and it is needed to perform RPF to the DPU through one or multiple subscriber lines.

When the copper cable access system supplies power for the DPU of a local device, it brings an interference source to the subscriber line while bringing electrical energy to the DPU. Power supply noise is an electromagnetic interference, and the frequency spectrum of conduction noise is roughly 10kHz to 30MHz, up to 150MHz. The power supply noise, especially a transient noise interference, is high in rising velocity, short in duration, high in voltage amplitude, strong in randomness, and easy to generate a serious interference to a microcomputer and a digital circuit.

The inventor finds in a research process that although there is a Power Splitter (PS), for filtering a high-frequency signal of a power supply, in the RPF system, there is always the possibility of parts faults of the PSE and the PS. However, in the related art, when the communication quality of an RPF line is poor, although an alarm is reported to a network management system, the network management system cannot learn the reason of alarm according to the alarm of communication quality, so it is impossible to identify whether the deterioration of communication quality is caused by the power supply noise of the RPF line; moreover, a technology of vectoring among lines is adopted in a G.fast system, and the introduction of power supply noise of a certain line will affect the normal work of other lines, which disables the network management system to accurately locate the reason of faults.

Aiming at the problem that when there is power supply noise interference, an RPF line will affect the normal work of its own and other lines, an effective solution has not been presented.

Document LES BROWN HUAWEI CHINA:" Draft Recommendation ITU-T G.9701 (for Consent, 6 December 2013)", ITU-T DRAFT provides related technical solutions; however, the above mentioned problem still remains unsolved.

### Summary

The following is an overview of the theme elaborated in the present invention. The overview is not intended to limit the scope of protection of the claims.

The present invention provides a method and device for processing RPF line detection.

The method for processing RPF line detection includes that: it is detected whether communication quality parameters of an RPF line exceed a preset range; when the detection result is yes, it is analyzed whether the reason causing the communication quality parameters of the RPF line to exceed the preset range is power supply noise; and when the analysis result is yes, the power supply of the RPF line is cut off or the power supply cut-off state of the RPF line is maintained, and the analysis result and/or processing result of the RPF line are/is reported to a network management system.

In an embodiment, the communication quality parameters include: Signal to Noise Ratio (SNR), and/or a line attenuation value.

In an embodiment, the step of detecting whether the communication quality parameters of the RPF line exceed the preset range includes that: in an initialization process of the start of the RPF line or in a work process of the RPF line, it is detected whether the communication quality parameters of the RPF line exceed the preset range.

In an embodiment, that it is analyzed whether the reason causing the communication quality parameters of the RPF line to exceed the preset range is the power supply noise includes that: it is analyzed whether the reason causing the communication quality parameters of the RPF line to exceed the preset range is the power supply noise by comparing the communication quality parameters of the RPF line in the power supply state and the power supply cut-off state.

In an embodiment, that it is analyzed whether the reason causing the communication quality parameters of the RPF line to exceed the preset range is the power supply noise includes that: it is judged whether the RPF line is unique; when it is judged that the RPF line is not the unique RPF line, the power supply of the RPF line is cut off; it is detected whether the communication quality parameters of the RPF line exceed the preset range; when the RPF line is in the power supply cut-off state and it is detected that the communication quality parameters of the RPF line do not exceed the preset range, it is determined that the reason causing the communication quality parameters of the RPF line to exceed the preset range is the power supply noise; when the RPF line is in the power supply cut-off state and it is detected that the communication quality parameters of the RPF line exceed the preset range, it is determined that the reason causing the communication quality parameters of the RPF line to exceed the preset range is not the power supply noise.

In an embodiment, when the RPF line is in the power supply cut-off state and it is detected that the communication quality parameters of the RPF line do not exceed the preset range, that it is analyzed whether the reason causing the communication quality parameters of the RPF line to exceed the preset range is the power supply noise further includes that: the monitoring result of a power supply noise monitoring module of a local side and a terminal is analyzed, and it is determined whether a PS of the local side or a PS of the terminal has problem.

In an embodiment, when it is judged that the RPF line is unique, it is analyzed whether the reason causing the communication quality parameters of the RPF line to exceed the preset range is the power supply noise further includes that: it is analyzed whether the power supply noise of the local side or the terminal is abnormal, and when it is analyzed that the power supply noise of the local side or the terminal is abnormal, it is determined that the reason causing the communication quality parameters of the RPF line to exceed the preset range is the power supply noise.

The device for processing RPF line detection includes: a communication quality detecting module, which is configured to detect whether the communication quality parameters of the RPF line exceed the preset range; a power supply noise analyzing module, which is configured to, when the detection result of the communication quality detecting module is yes, analyze whether the reason causing the communication quality parameters of the RPF line to exceed the preset range is the power supply noise; and a power supply noise processing module, which is configured to, when the analysis result of the power supply noise analyzing module is yes, cut off the power supply of the RPF line or maintain the power supply cut-off state of the RPF line, and report the analysis result and/or processing result of the RPF line to the network management system.

In an embodiment, the communication quality parameters include: the SNR, and/or the line attenuation value.

In an embodiment, the communication quality detecting module is configured to, in the initialization process of the start of the RPF line or in the work process of the RPF line, detect whether the communication quality parameters of the RPF line exceed the preset range.

In an embodiment, the power supply noise analyzing module includes: a judging unit, which is configured to judge whether the RPF line is unique; a power supply cut-off unit, which is configured to, when the judging unit judges that the RPF line is not the unique RPF line, cut off the power supply of the RPF line; a communication quality detecting unit, which is configured to detect whether the communication quality parameters of the RPF line exceed the preset range; a first power supply noise analyzing unit, which is configured to, when the RPF line is in the power supply cut-off state and the communication quality detecting unit detects that the communication quality parameters of the RPF line do not exceed the preset range, determine that the reason causing the communication quality parameters of the RPF line to exceed the preset range is the power supply noise, and when the RPF line is in the power supply cut-off state and the communication quality detecting unit detects that the communication quality parameters of the RPF line exceed the preset range, determine that the reason causing the communication quality parameters of the RPF line to exceed the preset range is not the power supply noise.

In an embodiment, the power supply noise analyzing module further includes: a second power supply noise analyzing unit, which is configured to, when the RPF line is in the power supply cut-off state and it is detected that the communication quality parameters of the RPF line do not exceed the preset range, analyze the monitoring result of the power supply noise monitoring module of the local side and the terminal, and determine whether the PS of the local side or the PS of the terminal has problem.

In an embodiment, the power supply noise analyzing module further includes: a third power supply noise analyzing unit, which is configured to, when it is judged that the RPF line is unique, analyze whether the power supply noise of the local side or the terminal is abnormal, and when it is analyzed that the power supply noise of the local side or the terminal is abnormal, determine that the reason causing the communication quality parameters of the RPF line to exceed the preset range is the power supply noise.

The present invention also provides a computer readable storage medium, in which a computer executable instruction is stored; the computer executable instruction is used for performing the above method.

According to the present invention, it is detected whether the communication quality parameters of the RPF line exceed the preset range; when the detection result is yes, it is analyzed whether the reason causing the communication quality parameters of the RPF line to exceed the preset range is the power supply noise; and when the analysis result is yes, the power supply of the RPF line is cut off or the power supply cut-off state of the RPF line is maintained, and the analysis result and/or processing result of the RPF line are/is reported to the network management system; in such a manner, the problem that when there is power supply noise interference, the RPF line will affect the normal work of its own and other lines is solved, the anti-interference ability of a system is improved, and the robustness of the system is enhanced.

Other aspects can be understood after the accompanying drawings and detailed descriptions are read and understood.

### Brief Description of the Drawings

Fig. 1 is a schematic diagram of a reference model of an FTTdp function according to the related art;
Fig. 2 is a flowchart of a method for processing RPF line detection according to an embodiment of the present invention;
Fig.3 is a structure diagram of a device for processing RPF line detection according to an embodiment of the present invention;
Fig. 4 is an optional structure diagram 1 of the device for processing RPF line detection according to an embodiment of the present invention;
Fig. 5 is an optional structure diagram 2 of the device for processing RPF line detection according to an embodiment of the present invention;
Fig. 6 is an optional structure diagram 3 of the device for processing RPF line detection according to an embodiment of the present invention;
Fig. 7 is a structure diagram of a system for processing RPF line detection according to an embodiment of the present invention;
Fig. 8 is a flowchart of a method for analyzing power supply noise according to an embodiment of the present invention; and
Fig. 9 is a flowchart of a method for processing power supply noise according to an embodiment of the present invention.

### Detailed Description of the Embodiments

The implementation modes of the present invention are elaborated below with reference to the accompanying drawings and embodiments. Note that, the embodiments in the application and the characteristics in the embodiments can be combined under the condition of no conflicts.

The technical solutions in the embodiments of the present invention are clearly and completely described below in combination with the accompanying drawings. Obviously, the described embodiments are only a part of the embodiments of the present invention but not all. Based on the embodiments of the present invention, all the other embodiments obtained by the ordinary skill in the art on the premise of not contributing creative effort belong to the scope of protection of the present invention.

An embodiment of the present invention provides a method for processing RPF line detection. Fig. 2 is a flowchart of the method for processing RPF line detection according to an embodiment of the present invention, as shown in Fig. 2, the flow includes the following steps:
S202: it is detected whether communication quality parameters of an RPF line exceed a preset range;
S204: when the detection result is yes, it is analyzed whether the reason causing the communication quality parameters of the RPF line to exceed the preset range is power supply noise; and
S206: when the analysis result is yes, the power supply of the RPF line is cut off or the power supply cut-off state of the RPF line is maintained, and the analysis result and/or processing result of the RPF line are/is reported to a network management system.

Through the above steps, when the communication quality parameters of the RPF line exceed the preset range, it is detected whether the reason causing the communication quality parameters of the RPF line to exceed the preset range is power supply noise, and when the analysis result is yes, the power supply of the RPF line is cut off or the power supply cut-off state of the RPF line is maintained, and the analysis result and/or processing result of the RPF line are/is reported to the network management system. By adopting the above solution, the power supply noise can be identified and detected, and the power supply of the RPF line with the power supply noise is cut off to avoid the influence of the power supply noise in time, so the problem that when there is power supply noise interference, the RPF line will affect the normal work of its own and other lines is solved, the anti-interference ability of the system is improved, and the robustness of the system is enhanced.

Note that, the preset range is the range in which the communication quality parameters are normal. In an embodiment, the communication quality parameters include: the SNR, and/or the line attenuation value.

In an embodiment, the above solution can be applied to different scenarios, for example, in an initialization process of the start of the RPF line or in a work process of the RPF line. The embodiment of the present invention does not limit the application scenarios and systems supported of the above solution, that is, the effective processing of the RPF line in the presence of noise interference which can be implemented by adopting the solution should fall within the application range of the solution described in the embodiment of the present invention.

In an embodiment, in S204, it is possible to analyze whether the reason causing the communication quality parameters of the RPF line to exceed the preset range is the power supply noise by comparing the communication quality parameters of the RPF line in the power supply state and the power supply cut-off state.

For the same local device, a possible application scenario is that a unique terminal device is adopted to perform RPF; certainly, RPF can also be performed through multiple pieces of terminal device, and multiple RPF lines formed supply power to the local device according to a predetermined policy or adaptively. For the way that multiple RPF lines perform the RPF, it is possible to directly cut off the RPF line, and the other RPF lines continue to supply power for the local device; for the way that only one RPF line performs the RPF, after the RPF to the local device is cut off, the local device will be powered off.

In an embodiment, in S204, it is possible to judge whether the RPF line is unique, and then according to the judgement result, adopt the corresponding way to detect the reason causing the communication quality parameters of the RPF line to exceed the preset range is the power supply noise.

For example, when the judgement result is that the RPF line is not the unique RPF line, that is, when there are multiple RPF lines performing RPF to the local device, the power supply of the RPF line can be cut off; at the same time, it is detected whether the communication quality parameters of the RPF line exceed the preset range when the RPF line is in the power supply cut-off state; when the detection result is that the communication quality parameters of the RPF line still exceed the preset range, it can be determined that the reason causing the communication quality parameters to deteriorate is not the power supply noise of the RPF line. At this point, it is possible to restart the power supply of the RPF line, and report the analysis result and the processing result to the network management system.

In the above implementation mode, after the power supply of the RPF line is cut off, if it is detected that the communication quality parameters on the RPF line of the RPF line do not exceed the preset range, it is indicated that the power supply noise of the RPF line may well cause the deterioration of the communication quality, then it is possible to restart the power supply of the RPF line and monitor whether the power supply noise of the local device and the terminal device of the RPF line is abnormal; when the monitoring result is that the power supply noise of the local device or the terminal device is abnormal, the power supply of the RPF line can be cut off. Information about processing the RPF line and the analysis result of the power supply noise can be reported to the network management system, or after the analysis result of the power supply noise is reported to the network management system, the power supply of the RPF line is cut off according to the indication of the network management system.

For example, when the judgement result is that the RPF line is unique, it can be detected whether the reason causing the communication quality parameters of the RPF line to exceed the preset range is the power supply noise by detecting whether the power supply noise of the local device or the terminal device is abnormal. When it is detected that the power supply noise of the local side or the terminal device is abnormal, the power supply of the RPF line can be cut off. The information about processing the RPF line and the analysis result of the power supply noise can be reported to the network management system; or after the detection result of the power supply noise is reported to the network management system, the power supply of the RPF line can be cut off according to the indication of the network management system.

The present embodiment also provides a device for processing RPF line detection, which is used for implementing the above embodiments and optional implementation modes; the embodiments and implementation modes which have been elaborated will not be repeated herein. The term "module" used below can realize a combination of software and/or hardware with an intended function. Although the device described in the following embodiment is realized through software better, the realization through hardware or a combination of software and hardware is possible and conceived.

Fig.3 is a structure diagram of the device for processing RPF line detection according to an embodiment of the present invention; as shown in Fig. 3, the device includes: a communication quality detecting module 32, a power supply noise analyzing module 34, and a power supply noise processing module 36. The communication quality detecting module 32 is configured to detect whether the communication quality parameters of the RPF line exceed the preset range; the power supply noise analyzing module 34 is coupled to the configured to the communication quality detecting module 32, and is configured to, when the detection result of the communication quality detecting module 32 is yes, analyze whether the reason causing the communication quality parameters of the RPF line to exceed the preset range is the power supply noise; the power supply noise processing module 36 is coupled to the power supply noise analyzing module 34, and is configured to, when the analysis result of the power supply noise analyzing module 34 is yes, cut off the power supply of the RPF line or maintain the power supply cut-off state of the RPF line, and report the analysis result and/or processing result of the RPF line to the network management system.

By means of the combined action of the above modules, the problem that when there is power supply noise interference, the RPF line will affect the normal work of its own and other lines is solved, the anti-interference ability of the system is improved, and the robustness of the system is enhanced.

In an embodiment, the communication quality parameters include: the SNR, and/or the line attenuation value.

In an embodiment, the communication quality detecting module 32 is configured to, in the initialization process of the start of the RPF line or in the work process of the RPF line, detect whether the communication quality parameters of the RPF line exceed the preset range.

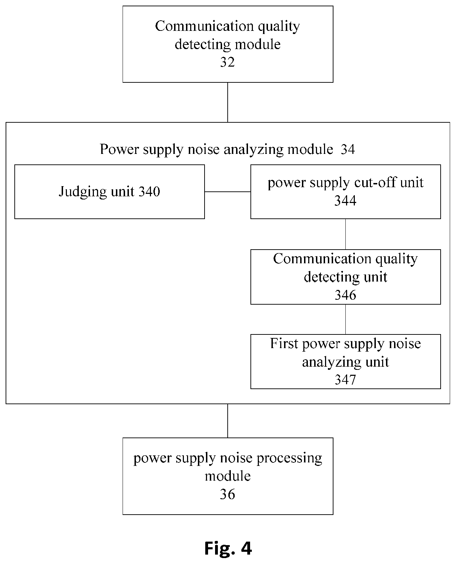

Fig. 4 is an optional structure diagram 1 of the device for processing RPF line detection according to an embodiment of the present invention; as shown in Fig. 4, in an embodiment, the power supply noise analyzing module 34 includes: a judging unit 340, which is configured to judge whether the RPF line is unique; a power supply cut-off unit 344, which is coupled to the judging unit 340, and is configured to, when the judging unit 340 judges that the RPF line is not the unique RPF line, cut off the power supply of the RPF line; a communication quality detecting unit 346, which is coupled to the power supply cut-off unit 344, and is configured to detect whether the communication quality parameters of the RPF line exceed the preset range; a first power supply noise analyzing unit 347, which is coupled to the communication quality detecting unit 346, and is configured to, when the RPF line is in the power supply cut-off state and the communication quality detecting unit 346 detects that the communication quality parameters of the RPF line do not exceed the preset range, determine that the reason causing the communication quality parameters of the RPF line to exceed the preset range is the power supply noise, and when the RPF line is in the power supply cut-off state and the communication quality detecting unit 346 detects that the communication quality parameters of the RPF line exceed the preset range, determine that the reason causing the communication quality parameters of the RPF line to exceed the preset range is not the power supply noise.

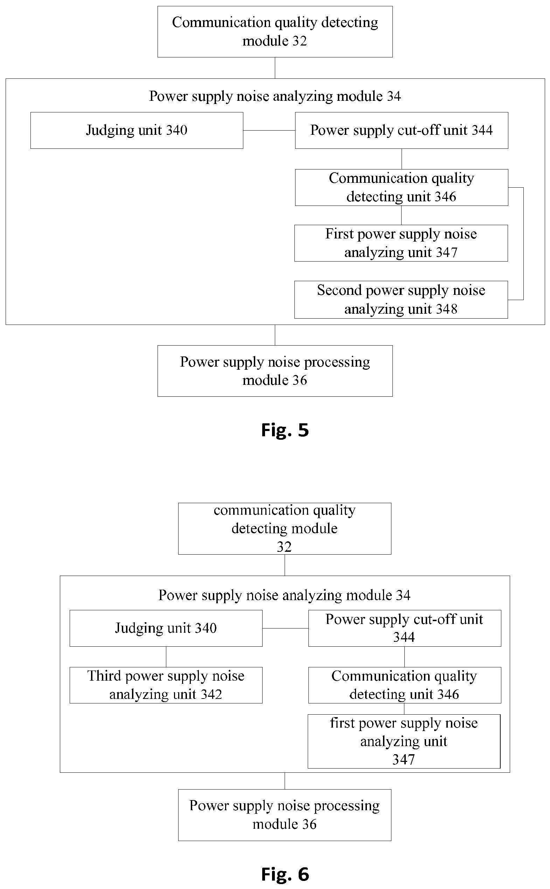

Fig. 5 is an optional structure diagram 2 of the device for processing RPF line detection according to an embodiment of the present invention; as shown in Fig. 5, in an embodiment, the power supply noise analyzing module 34 further includes: a second power supply noise analyzing unit 348, which is coupled to the communication quality detecting unit 346, and is configured to, when the RPF line is in the power supply cut-off state and it is detected that the communication quality parameters of the RPF line do not exceed the preset range, analyze the monitoring result of the power supply noise monitoring module of the local side and the terminal, and determine whether the PS of the local side or the PS of the terminal has problem.

Fig. 6 is an optional structure diagram 3 of the device for processing RPF line detection according to an embodiment of the present invention; as shown in Fig. 6, in an embodiment, the power supply noise analyzing module 34 further includes: a third power supply noise analyzing unit 342, which is coupled to the judging unit 340, and is configured to, when it is judged that the RPF line is unique, analyze whether the power supply noise of the local side or the terminal is abnormal, and when it is analyzed that the power supply noise of the local side or the terminal is abnormal, determine that the reason causing the communication quality parameters of the RPF line to exceed the preset range is the power supply noise.

Moreover, the functional units in the embodiment of the present invention can either be integrated in a processing unit or exist physically; or two or more than two units can be integrated in a unit. The above integrated units can be realized in form of hardware or software functional unit.

The present invention is described and illustrated below through optional embodiments.

An optional embodiment of the present invention provides a method for processing monitoring based on an RPF line, relating to an RPF technology.

In an optional embodiment of the present invention, based on the characteristics of an RPF system architecture in copper cable access systems (including, but not limited to, G.fast, VDSL2, and so on), a method and processing mechanism for automatic detection of communication line quality in an RPF power supply scenario are presented. Through the optional embodiment, the power supply noise in a communication line can be monitored in real time; when the communication line quality becomes abnormal, the power supply noise can be identified and detected, at the same time, the influence of the power supply noise is avoided in time, so as to enhance the robustness of the copper cable access system in an RPF power supply environment.

The method provided in the optional embodiment of the present invention includes the following two scenarios.
Scenario 1: in an initialization process of the start of line, the health of a power feed line is detected; when the line quality is poor (which is detected through whether the communication quality parameters, for example, the SNR or the line attenuation value, exceed the set normal range), the fault is located; when it is detected that there is serious power supply noise in the RPF line, the start of the line is stopped and the power supply of the line is cut off, and the situation can be reported to the network management system to indicate that the line has a power supply problem.
Scenario 2: in a normal work situation of line, the health of the power feed line is monitored in real time; when the line quality is poor (which is detected through whether the communication quality parameters, for example, the SNR or the line attenuation value, exceed the set normal range), the line fault caused by the power supply noise can be located; when it is detected that there is serious power supply noise in the RPF line, the power supply of the line is cut off, and the situation is be reported to the network management system to indicate that the line has a power supply problem.

Through the above solution, based on the characteristics of the RPF system architecture in the copper cable access systems (such as G.fast and VDSL2), a method and processing mechanism for automatic detection of communication line quality in an RPF power supply scenario are presented; through the method and the processing mechanism, the power supply noise in the communication line can be monitored in real time; when the communication line quality becomes abnormal, the power supply noise can be identified and detected, and the influence of the power supply noise is avoided in time; at the same time, the power supply problem existing in the line is reported to the network management system; as such, a wealth of information about line quality analysis can be provided to the network management system and other DSL detection systems (e.g. a Metallic Line Testing (MELT) system), so as to facilitate accurate location of the faults of network links and devices, and realize intellectualized operation and management of the copper cable access system.

The optional embodiments of the present invention are described and illustrated below with reference to the accompanying drawings.

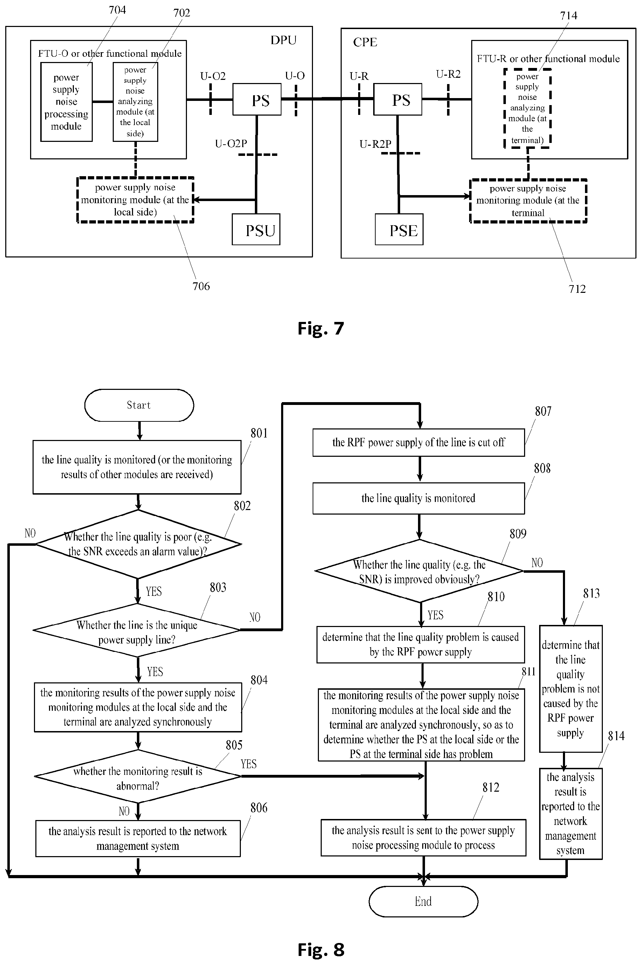

A system for processing RPF line detection is mainly used for identifying and detecting the power supply noise in the power feed line, and when the power supply noise is detected, can adopt related processing mechanism to avoid the influence of the power supply noise in time and report it to the network management system. Fig. 7 is a structure diagram of the system for processing RPF line detection according to an optical embodiment of the present invention; Fig. 7 is a deformation form of Fig. 3 to Fig. 6; as shown in Fig. 7, the system for processing RPF line detection includes a power supply noise analyzing module (at the local side) 702 and a power supply noise processing module 704, which are realized in the local device (e.g. a DPU) in the copper cable access system; at the same time, the two modules can be either embedded in or independent of xTU-O. In Fig. 7, U-R is a reference point at CPE containing both DC power and service data); U-R2 is a reference point at CPE containing the filtered service data; U-O is a reference point at DPU containing both DC power and service data; U-O2 is a reference point at DPU containing the filtered service data; PSU represents a power supply unit; the xTU-O is an FAST Transceiver Unit (FTU-O) at the local side or a VDSL2 Transceiver Unit (VTU-O) at the local side. Besides, for accurately locating the reason causing the power supply noise to generate, the system for processing RPF line detection may also a power supply noise monitoring module (at the local side) 706, a power supply noise monitoring module (at the terminal) 712, and a power supply noise analyzing module (at the terminal) 714. The main functions of the modules are as follows:
the power supply noise analyzing module (at the local side) 702 starts, when the line quality has a problem (e.g. the SNR value has a deviation, working to respectively analyze signal transmission conditions when the line is performing the RPF and not performing the RPF, compares the analysis results in the two cases to check whether the line quality problem is caused by the RPF; at the same time, it can also comprehensively analyze information about monitoring and analyzing which is sent by each module to locate the reason causing the fault of the RPF communication line (e.g. whether the fault is caused by the PS of the local side or the PS of the terminal side);
the power supply noise processing module 704 receives the analysis result of the power supply noise analyzing module (at the local side) 702, executes the corresponding actions according to the policy, wherein the actions mainly include cutting off the power supply of the line, and reporting the reason causing the fault and processing information thereof to the network management system;
the power supply noise monitoring module (at the local side) 706 monitors a power supply noise condition of a reference point at DPU containing the extracted DC power (U-O2P) access line, and sends the monitoring result (e.g. whether a noise distribution band of output power of the PS exceeds the preset range) to the power supply noise analyzing module (at the local side) 702;
the power supply noise monitoring module (at the terminal) 712 monitors a power supply noise condition of a reference point at CPE containing the injected DC power (U-R2P) access line, and sends the monitoring result (e.g. whether the noise distribution band of output power of the PSE exceeds the preset range) to the power supply noise analyzing module (at the terminal) 714;
the power supply noise analyzing module (at the terminal) 714 receives the monitoring result of the power supply noise monitoring module (at the terminal) 712, and reports the analysis result of the power supply noise at the terminal side to the local side.

The working flow of the system shown in Fig. 7 is introduced below.

A method for analyzing power supply noise is provided.

Fig. 8 is a flowchart of the method for analyzing power supply noise according to an optical embodiment of the present invention; as shown in Fig. 8, the flow includes the following steps.

S801: in the initialization process or the working process of a subscriber line of the copper cable access system, the line quality is monitored, or the monitoring results of other modules are received.

S802: it is judged whether the line quality is poor; when the line quality is normal, the flow of analyzing the power supply noise is terminated; when the line quality is poor (note that, it can be judged according to whether the communication quality parameters (e.g. the SNR or the line attenuation value) exceed the set normal range), the following flow is executed.

S803: it is analyzed and judged whether the subscriber line is the unique RPF line of the local device of the copper cable access system. If the line is the unique RPF line, S804 is performed; if the line is not the unique RPF line, that is, there are multiple subscriber lines performing RPF to the local device, S807 is performed.

S804: the monitoring results of the power supply noise monitoring modules at the local side and the terminal are analyzed synchronously.

S805: it is judged whether the monitoring result is abnormal; if the monitoring result is normal, S806 is performed; if the monitoring result is abnormal, S812 is performed.

S806: the analysis result is reported to the network management system, and the flow ends.

S807: the RPF power supply of the line is cut off.

S808: the line quality is monitored.

S809: it is judged whether the line quality is improved obviously; if the line quality is not improved obviously (note that, it can be judged according to whether the communication quality parameters (e.g. the SNR or the line attenuation value) exceed the set range), S813 is performed; if the line quality is improved obviously, S810 is performed.

S810: it is determined that the line quality problem is caused by the RPF power supply.

S811: the monitoring results of the power supply noise monitoring modules at the local side and the terminal are analyzed synchronously, so as to determine whether the PS at the local side or the PS at the terminal side has problem.

S812: the analysis result is sent to the power supply noise processing module to process, and the flow ends.

S813: it is determined that the line quality problem is not caused by the RPF power supply.

S814: the analysis result is reported to the network management system, and the flow ends.

A method for processing power supply noise is provided.

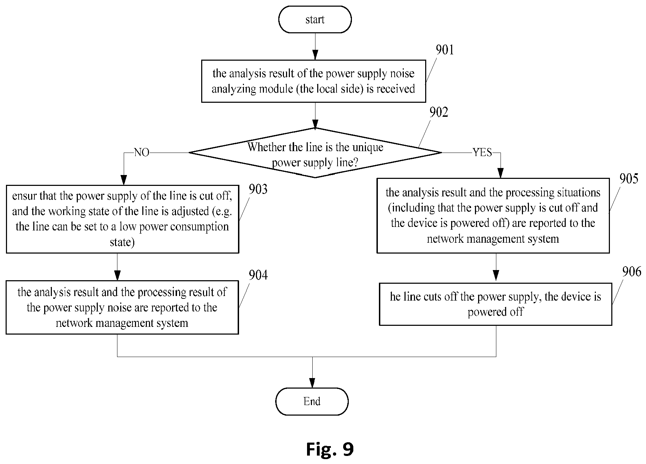

Fig. 9 is a flowchart of the method for processing power supply noise according to an optical embodiment of the present invention; as shown in Fig. 9, the flow includes the following steps.

S901: the analysis result of the power supply noise analyzing module (the local side) is received.

S902: it is judged whether the line is the unique power feed line of the local device of the copper cable access system; if the line is not the unique power feed line, S903 is performed; if the line is the unique power feed line, S905 is performed.

S903: the power supply of the line is cut off, and the working state of the line is adjusted (e.g. the line can be set to a low power consumption state).

S904: the analysis result and the processing result of the power supply noise are reported to the network management system, and the flow ends.

S905: the analysis result and the processing situations (including that the power supply is cut off and the device is powered off) are reported to the network management system.

S906: the line cuts off the power supply, the device is powered off, and the flow ends.

In another embodiment, a piece of software is also provided, which is used for performing the technical solutions described in the above embodiments and optional implementation modes.

In another embodiment, a storage medium is also provided, in which the software is stored; the storage medium includes, but is not limited to, a compact disc, a floppy disk, a hard disk, an erasable memory, and so on.

Note that, the terms like "first" and "second" in the specification, the claims and the accompanying drawings of the present invention are used for differentiating the similar objects, but do not have to describe a specific order or a sequence. It should be understood that the objects can be exchanged under appropriate circumstances, so that the embodiments of the present invention described here can be implemented in an order different from that described or shown here. Moreover, the terms like "include" and "have" and any variation of them are intended to cover nonexclusive including; for example, the process, method, system, product or device including a series of steps or units do not have to be limited to those clearly listed steps or units, but can include other steps or units which are not clearly listed or inherent in these process, method, system, product or device.

Obviously, those skilled in the art should appreciate that the above modules and steps of the present invention can be implemented by a general-purpose computing device, and they can be centralized in a single computing device or distributed on a network composed of multiple computing devices; in an embodiment, they can be implemented by a program code which is capable of being executed by the computing device, so that they can be stored in a storage device and executed by the computing device; in some cases, the presented or described steps can be performed in a sequence different from that herein, or they are made into integrated circuit modules respectively, or multiple modules and steps of them are made into a single integrated circuit module to implement. Thus, the present invention is not limited to any particular combination of hardware and software.

The above is only the optional embodiments of the present invention and not intended to limit the present invention; for those skilled in the art, the present invention may have various modifications and changes. Any modifications, equivalent replacements, improvements and the like within the principle of the present invention shall fall within the scope of protection of the present invention.

### Industrial Applicability

Through the present invention, the power supply noise can be identified and detected, and the power supply of the RPF line with the power supply noise is cut off to avoid the influence of the power supply noise in time, so the problem that when there is power supply noise interference, the RPF line will affect the normal work of its own and other lines is solved, the anti-interference ability of the system is improved, and the robustness of the system is enhanced.

## Claims

1. A method for processing Remote Power Feed, RPF, line detection, comprising:
detecting whether communication quality parameters of an RPF line in an RPF system exceed a preset range (S202);
when the detection result is yes, analyzing whether the reason causing the communication quality parameters of the RPF line to exceed the preset range is power supply noise (S204) of Power Supply Equipment, PSE, of the RPF system; and
when the analysis result is yes, cutting off the power supply of the RPF line or maintaining the power supply cut-off state of the RPF line, and reporting the analysis result and/or processing result of the RPF line to a network management system (S206).

2. The method as claimed in claim 1, wherein the communication quality parameters comprise:
Signal to Noise Ratio (SNR), and/or a line attenuation value.

3. The method as claimed in claim 1, wherein detecting whether the communication quality parameters of the RPF line exceed the preset range (S202) comprises:
in an initialization process of the start of the RPF line or in a work process of the RPF line, detecting whether the communication quality parameters of the RPF line exceed the preset range.

4. The method as claimed in claim 1, wherein analyzing whether the reason causing the communication quality parameters of the RPF line to exceed the preset range is the power supply noise (S204) comprises:
analyzing whether the reason causing the communication quality parameters of the RPF line to exceed the preset range is the power supply noise by comparing the communication quality parameters of the RPF line in the power supply state and the power supply cut-off state.

5. The method as claimed in claim 1, wherein analyzing whether the reason causing the communication quality parameters of the RPF line to exceed the preset range is the power supply noise (S204) comprises:
judging whether the RPF line is unique;
when it is judged that the RPF line is not the unique RPF line, cutting off the power supply of the RPF line;
detecting whether the communication quality parameters of the RPF line exceed the preset range;
when the RPF line is in the power supply cut-off state and it is detected that the communication quality parameters of the RPF line do not exceed the preset range, determining that the reason causing the communication quality parameters of the RPF line to exceed the preset range is the power supply noise; when the RPF line is in the power supply cut-off state and it is detected that the communication quality parameters of the RPF line exceed the preset range, determining that the reason causing the communication quality parameters of the RPF line to exceed the preset range is not the power supply noise.

6. The method as claimed in claim 5, wherein when the RPF line is in the power supply cut-off state and it is detected that the communication quality parameters of the RPF line do not exceed the preset range, analyzing whether the reason causing the communication quality parameters of the RPF line to exceed the preset range is the power supply noise comprises:
analyzing the monitoring result of a power supply noise monitoring module of a local side and a terminal, and determining whether a Power Splitter (PS) of the local side or a PS of the terminal has problem.

7. The method as claimed in claim 5, when it is judged that the RPF line is unique, analyzing whether the reason causing the communication quality parameters of the RPF line to exceed the preset range is the power supply noise comprises:
analyzing whether the power supply noise of the local side or the terminal is abnormal, and when it is analyzed that the power supply noise of the local side or the terminal is abnormal, determining that the reason causing the communication quality parameters of the RPF line to exceed the preset range is the power supply noise.

8. A device for processing Remote Power Feed, RPF, line detection, comprising:
a communication quality detecting module (32), which is configured to detect whether communication quality parameters of an RPF line in an RPF system exceed a preset range (S202);
a power supply noise analyzing module (34), which is configured to, when the detection result of the communication quality detecting module (32) is yes, analyze whether the reason causing the communication quality parameters of the RPF line to exceed the preset range is power supply noise (S204) of Power Supply Equipment, PSE, of the RPF system; and
a power supply noise processing module (36), which is configured to, when the analysis result of the power supply noise analyzing module (34) is yes, cut off the power supply of the RPF line or maintain the power supply cut-off state of the RPF line, and report the analysis result and/or processing result of the RPF line to a network management system (S206).

9. The device as claimed in claim 8, wherein the communication quality parameters comprise:
Signal to Noise Ratio (SNR), and/or a line attenuation value.

10. The device as claimed in claim 8, wherein the communication quality detecting module (32) is configured to, in an initialization process of the start of the RPF line or in a work process of the RPF line, detect whether the communication quality parameters of the RPF line exceed the preset range.

11. The device as claimed in claim 8, wherein the power supply noise analyzing module (34) comprises:
a judging unit (340), which is configured to judge whether the RPF line is unique;
a power supply cut-off unit (344), which is configured to, when the judging unit (340) judges that the RPF line is not the unique RPF line, cut off the power supply of the RPF line;
a communication quality detecting unit (346), which is configured to detect whether the communication quality parameters of the RPF line exceed the preset range;
a first power supply noise analyzing unit (347), which is configured to, when the RPF line is in the power supply cut-off state and the communication quality detecting unit (346) detects that the communication quality parameters of the RPF line do not exceed the preset range, determine that the reason causing the communication quality parameters of the RPF line to exceed the preset range is the power supply noise, and when the RPF line is in the power supply cut-off state and the communication quality detecting unit (346) detects that the communication quality parameters of the RPF line exceed the preset range, determine that the reason causing the communication quality parameters of the RPF line to exceed the preset range is not the power supply noise.

12. The device as claimed in claim 11, wherein the power supply noise analyzing module (34) further comprises:
a second power supply noise analyzing unit (348), which is configured to, when the RPF line is in the power supply cut-off state and it is detected that the communication quality parameters of the RPF line do not exceed the preset range, analyze the monitoring result of a power supply noise monitoring module of a local side and a terminal, and determine whether a Power Splitter (PS) of the local side or a PS of the terminal has problem.

13. The device as claimed in claim 11, wherein the power supply noise analyzing module (34) further comprises:
a third power supply noise analyzing unit (342), which is configured to, when it is judged that the RPF line is unique, analyze whether the power supply noise of the local side or the terminal is abnormal, and when it is analyzed that the power supply noise of the local side or the terminal is abnormal, determine that the reason causing the communication quality parameters of the RPF line to exceed the preset range is the power supply noise.

## Patentansprüche

1. Verfahren zur Verarbeitung einer Fernspeisungs-, RPF-Leitungserkennung, umfassend:
Erkennen, ob Kommunikationsqualitätsparameter einer RPF-Leitung in einem RPF-System einen voreingestellten Bereich (S202) übertreffen;
wenn das Erkennungsergebnis ja ist, Analysieren, ob die Ursache für das Bewirken, dass die Kommunikationsqualitätsparameter der RPF-Leitung einen voreingestellten Bereich übertreffen, Stromversorgungsrauschen (S204) der Stromversorgungsausrüstung, PSE, des RPF-Systems ist; und
wenn das Analyseergebnis ja ist, Abschalten der Stromversorgung der RPF-Leitung oder Beibehalten des Stromversorgungs-Abschaltzustandes der RPF-Leitung und Berichten des Analyseergebnisses und/oder Verarbeitungsergebnisses der RPF-Leitung an ein Netzwerkverwaltungssystem (S206).

2. Verfahren nach Anspruch 1, wobei die Kommunikationsqualitätsparameter umfassen:
Signal-Rausch-Verhältnis (SNR), und/oder Leitungsdämpfungswert.

3. Verfahren nach Anspruch 1, wobei das Erkennen, ob die Kommunikationsqualitätsparameter der RPF-Leitung einen voreingestellten Bereich (S202) übertreffen umfasst:
in einem Initialisierungsprozess des Starts der RPF-Leitung oder in einem Arbeitsprozess der RPF-Leitung Erkennen, ob die Kommunikationsqualitätsparameter der RPF-Leitung einen voreingestellten Bereich übertreffen.

4. Verfahren nach Anspruch 1, wobei das Analysieren, ob die Ursache für das Bewirken, dass die Kommunikationsqualitätsparameter der RPF-Leitung einen voreingestellten Bereich übertreffen, Stromversorgungsrauschen (S204) ist, umfasst:
Analysieren, ob die Ursache für das Bewirken, dass die Kommunikationsqualitätsparameter der RPF-Leitung den voreingestellten Bereich übertreffen, Stromversorgungsrauschen ist, durch Vergleichen der Kommunikationsqualitätsparameter der RPF-Leitung in dem Stromversorgungszustand und dem Stromversorgungs-Abschaltzustand.

5. Verfahren nach Anspruch 1, wobei das Analysieren, ob die Ursache für das Bewirken, dass die Kommunikationsqualitätsparameter der RPF-Leitung einen voreingestellten Bereich übertreffen, Stromversorgungsrauschen (S204) ist, umfasst:
Beurteilen, ob die RPF-Leitung die einzige ist;
wenn beurteilt wird, dass die RPF-Leitung nicht die einzige RPF-Leitung ist, Abschalten der Stromversorgung der RPF-Leitung;
Erkennen, ob die Kommunikationsqualitätsparameter der RPF-Leitung den voreingestellten Bereich übertreffen;
wenn die RPF-Leitung in dem Stromversorgungs-Abschaltzustand ist und erkannt wird, dass die Kommunikationsqualitätsparameter der RPF-Leitung den voreingestellten Bereich nicht übertreffen, Bestimmen, dass die Ursache für das Bewirken, dass die Kommunikationsqualitätsparameter der RPF-Leitung einen voreingestellten Bereich übertreffen, Stromversorgungsrauschen ist; wenn die RPF-Leitung in dem Stromversorgungs-Abschaltzustand ist und erkannt wird, dass die Kommunikationsqualitätsparameter der RPF-Leitung den voreingestellten Bereich übertreffen, Bestimmen, dass die Ursache für das Bewirken, dass die Kommunikationsqualitätsparameter der RPF-Leitung einen voreingestellten Bereich übertreffen, nicht das Stromversorgungsrauschen ist.

6. Verfahren nach Anspruch 5, wobei, wenn die RPF-Leitung in dem Stromversorgungs-Abschaltzustand ist und erkannt wird, dass die Kommunikationsqualitätsparameter der RPF-Leitung den voreingestellten Bereich nicht übertreffen, Analysieren, ob die Ursache für das Bewirken, dass die Kommunikationsqualitätsparameter der RPF-Leitung den voreingestellten Bereich übertreffen, Stromversorgungsrauschen ist, umfasst:
Analysieren des Überwachungsergebnisses eines Überwachungsmoduls für Stromversorgungsrauschen einer lokalen Seite und eines Endgeräts, und Bestimmen, ob ein Leistungsteiler (PS) der lokalen Seite oder ein PS des Endgeräts ein Problem aufweisen.

7. Verfahren nach Anspruch 5, wobei wenn beurteilt wird, dass die RPF-Leitung die einzige ist, das Analysieren, ob die Ursache für das Bewirken, dass die Kommunikationsqualitätsparameter der RPF-Leitung den voreingestellten Bereich übertreffen, Stromversorgungsrauschen ist, umfasst:
Analysieren, ob das Stromversorgungsrauschen der lokalen Seite oder des Endgeräts anormal ist, und wenn analysiert wird, dass das Stromversorgungsrauschen der lokalen Seite oder des Endgeräts anormal ist, Bestimmen, dass die Ursache für das Bewirken, dass die Kommunikationsqualitätsparameter der RPF-Leitung den voreingestellten Bereich übertreffen, das Stromversorgungsrauschen ist.

8. Vorrichtung zur Verarbeitung einer Fernspeisungs-, RPF-Leitungserkennung, umfassend:
ein Kommunikationsqualitätserkennungsmodul (32), das konfiguriert ist, um zu erkennen, ob Kommunikationsqualitätsparameter einer RPF-Leitung in einem RPF-System einen voreingestellten Bereich (S202) übertreffen;
ein Stromversorgungs-Rauschanalysemodul (34), das konfiguriert ist, um, wenn das Erkennungsergebnis des Kommunikationsqualitätserkennungsmoduls (32) ja ist, zu analysieren, ob die Ursache für das Bewirken, dass die Kommunikationsqualitätsparameter der RPF-Leitung einen voreingestellten Bereich übertreffen, Stromversorgungsrauschen (S204) der Stromversorgungsausrüstung, PSE, des RPF-Systems ist; und
ein Stromversorgung-Rauschverarbeitungsmodul (36), das konfiguriert ist, um wenn das Analyseergebnis des Stromversorgungs-Rauschanalysemoduls (34) ja ist, die Stromversorgung der RPF-Leitung abzuschalten oder den Stromversorgungs-Abschaltzustand der RPF-Leitung beizubehalten, und das Analyseergebnis und/oder Verarbeitungsergebnis der RPF-Leitung an ein Netzwerkverwaltungssystem (S206) zu berichten.

9. Vorrichtung nach Anspruch 8, wobei die Kommunikationsqualitätsparameter umfassen:
Signal-Rausch-Verhältnis (SNR), und/oder Leitungsdämpfungswert.

10. Vorrichtung nach Anspruch 8, wobei das Kommunikationsqualitätserkennungsmodul (32) konfiguriert ist, um in einem Initialisierungsprozess des Starts der RPF-Leitung oder in einem Arbeitsprozess der RPF-Leitung zu erkennen, ob die Kommunikationsqualitätsparameter der RPF-Leitung einen voreingestellten Bereich übertreffen.

11. Vorrichtung nach Anspruch 8, wobei das Stromversorgungs-Rauschanalysemodul (34) umfasst:
eine Beurteilungseinheit (340), die konfiguriert ist, um zu beurteilen, ob die RPF-Leitung die einzige ist;
eine Stromversorgungs-Abschalteinheit (344), die konfiguriert ist, um, wenn die Beurteilungseinheit (340), beurteilt, dass die RPF-Leitung nicht die einzige RPF-Leitung ist, die Stromversorgung der RPF-Leitung abzuschalten;
eine Kommunikationsqualitätserkennungseinheit (346), die konfiguriert ist, um zu erkennen, ob die Kommunikationsqualitätsparameter der RPF-Leitung den voreingestellten Bereich übertreffen;
eine erste Stromversorgungs-Rauschanalyseeinheit (347), die konfiguriert ist, um, wenn die RPF-Leitung in dem Stromversorgungs-Abschaltzustand ist und die Kommunikationsqualitätserkennungseinheit (346) erkennt, dass die Kommunikationsqualitätsparameter der RPF-Leitung den voreingestellten Bereich nicht übertreffen, zu bestimmen, dass die Ursache für das Bewirken, dass die Kommunikationsqualitätsparameter der RPF-Leitung einen voreingestellten Bereich übertreffen, das Stromversorgungsrauschen ist, und wenn die RPF-Leitung in dem Stromversorgungs-Abschaltzustand ist und die Kommunikationsqualitätserkennungseinheit (346) erkennt, dass die Kommunikationsqualitätsparameter der RPF-Leitung den voreingestellten Bereich übertreffen, zu bestimmen, dass die Ursache für das Bewirken, dass die Kommunikationsqualitätsparameter der RPF-Leitung einen voreingestellten Bereich übertreffen, nicht das Stromversorgungsrauschen ist.

12. Vorrichtung nach Anspruch 11, wobei das Stromversorgungs-Rauschanalysemodul (34) weiter umfasst:
eine zweite Stromversorgungs-Rauschanalyseeinheit (348), die konfiguriert ist, um, wenn die RPF-Leitung in dem Stromversorgungs-Abschaltzustand ist und erkannt wird, dass die Kommunikationsqualitätsparameter der RPF-Leitung den voreingestellten Bereich nicht übertreffen, das Überwachungsergebnis eines Überwachungsmoduls für Stromversorgungsrauschen einer lokalen Seite und eines Endgeräts zu analysieren, und zu bestimmen, ob ein Leistungsteiler (PS) der lokalen Seite oder ein PS des Endgeräts ein Problem aufweist.

13. Vorrichtung nach Anspruch 11, wobei das Stromversorgungs-Rauschanalysemodul (34) weiter umfasst:
eine dritte Stromversorgungs-Rauschanalyseeinheit (342), die konfiguriert ist, um, wenn beurteilt wird, dass die RPF-Leitung die einzige ist, zu analysieren, ob das Stromversorgungsrauschen der lokalen Seite oder des Endgeräts anormal ist, und wenn analysiert wird, dass das Rauschen der Stromversorgung der lokalen Seite oder des Endgeräts anormal ist, zu bestimmen, dass die Ursache für das Bewirken, dass die Kommunikationsqualitätsparameter der RPF-Leitung den voreingestellten Bereich übertreffen, das Stromversorgungsrauschen ist.

## Revendications

1. Procédé pour le traitement d'une détection de ligne de fourniture d'électricité à distance, RPF, comprenant :
la détection de si des paramètres de qualité de communication d'une ligne de RPF dans un système de RPF dépassent une plage prédéfinie (S202) ;
lorsque le résultat de détection est oui, l'analyse de si la raison amenant les paramètres de qualité de communication de la ligne de RPF à dépasser la plage prédéfinie est un bruit d'alimentation électrique (S204) d'un équipement d'alimentation électrique, PSE, du système de RPF ; et
lorsque le résultat d'analyse est oui, la coupure de l'alimentation électrique de la ligne de RPF ou le maintien de l'état de coupure d'alimentation électrique de la ligne de RPF, et le rapport du résultat d'analyse et/ou du résultat de traitement de la ligne de RPF à un système de gestion de réseau (S206).

2. Procédé selon la revendication 1, dans lequel les paramètres de qualité de communication comprennent :
un rapport signal sur bruit (SNR) et/ou une valeur d'atténuation de ligne.

3. Procédé selon la revendication 1, dans lequel la détection de si les paramètres de qualité de communication de la ligne de RPF dépassent la plage prédéfinie (S202) comprend :
dans un processus d'initialisation du démarrage de la ligne de RPF ou dans un processus de travail de la ligne de RPF, la détection de si les paramètres de qualité de communication de la ligne de RPF dépassent la plage prédéfinie.

4. Procédé selon la revendication 1, dans lequel l'analyse de si la raison amenant les paramètres de qualité de communication de la ligne de RPF à dépasser la plage prédéfinie est le bruit d'alimentation électrique (S204) comprend :
l'analyse de si la raison amenant les paramètres de qualité de communication de la ligne de RPF à dépasser la plage prédéfinie est le bruit d'alimentation électrique par la comparaison des paramètres de qualité de communication de la ligne de RPF dans l'état d'alimentation électrique et l'état de coupure d'alimentation électrique.

5. Procédé selon la revendication 1, dans lequel l'analyse de si la raison amenant les paramètres de qualité de communication de la ligne de RPF à dépasser la plage prédéfinie est le bruit d'alimentation électrique (S204) comprend :
l'évaluation de si la ligne de RPF est unique ;
lorsqu'il est évalué que la ligne de RPF n'est pas l'unique ligne de RPF, la coupure de l'alimentation électrique de la ligne de RPF ;
la détection de si les paramètres de qualité de communication de la ligne de RPF dépassent la plage prédéfinie ;
lorsque la ligne de RPF est dans l'état de coupure d'alimentation électrique et il est détecté que les paramètres de qualité de communication de la ligne de RPF ne dépassent pas la plage prédéfinie, la détermination que la raison amenant les paramètres de qualité de communication de la ligne de RPF à dépasser la plage prédéfinie est le bruit d'alimentation électrique ; lorsque la ligne de RPF est dans l'état de coupure d'alimentation électrique et il est détecté que les paramètres de qualité de communication de la ligne de RPF dépassent la plage prédéfinie, la détermination que la raison amenant les paramètres de qualité de communication de la ligne de RPF à dépasser la plage prédéfinie n'est pas le bruit d'alimentation électrique.

6. Procédé selon la revendication 5, dans lequel lorsque la ligne de RPF est dans l'état de coupure d'alimentation électrique et il est détecté que les paramètres de qualité de communication de la ligne de RPF ne dépassent pas la plage prédéfinie, l'analyse de si la raison amenant les paramètres de qualité de communication de la ligne de RPF à dépasser la plage prédéfinie est le bruit d'alimentation électrique comprend :
l'analyse du résultat de surveillance d'un module de surveillance de bruit d'alimentation électrique d'un côté local et d'un terminal, et la détermination de si un diviseur électrique (PS) du côté local ou un PS du terminal présente un problème.

7. Procédé selon la revendication 5, lorsqu'il est évalué que la ligne de RPF est unique, l'analyse de si la raison amenant les paramètres de qualité de communication de la ligne de RPF à dépasser la plage prédéfinie est le bruit d'alimentation électrique comprend :
l'analyse de si le bruit d'alimentation électrique du côté local ou du terminal est anormal, et lorsqu'il est analysé que le bruit d'alimentation électrique du côté local ou du terminal est anormal, la détermination que la raison amenant les paramètres de qualité de communication de la ligne de RPF à dépasser la plage prédéfinie est le bruit d'alimentation électrique.

8. Dispositif pour le traitement d'une détection de ligne de fourniture d'électricité à distance, RPF, comprenant :
un module de détection de qualité de communication (32), qui est configuré pour détecter si des paramètres de qualité de communication d'une ligne de RPF dans un système de RPF dépassent une plage prédéfinie (S202) ;
un module d'analyse de bruit d'alimentation électrique (34), qui est configuré pour, lorsque le résultat de détection du module de détection de qualité de communication (32) est oui, analyser si la raison amenant les paramètres de qualité de communication de la ligne de RPF à dépasser la plage prédéfinie est un bruit d'alimentation électrique (S204) d'un équipement d'alimentation électrique, PSE, du système de RPF ; et
un module de traitement de bruit d'alimentation électrique (36), qui est configuré pour, lorsque le résultat d'analyse du module d'analyse de bruit d'alimentation électrique (34) est oui, couper l'alimentation électrique de la ligne de RPF ou maintenir l'état de coupure d'alimentation électrique de la ligne de RPF, et rapporter le résultat d'analyse et/ou le résultat de traitement de la ligne de RPF à un système de gestion de réseau (S206).

9. Dispositif selon la revendication 8, dans lequel les paramètres de qualité de communication comprennent :
un rapport signal sur bruit (SNR) et/ou une valeur d'atténuation de ligne.

10. Dispositif selon la revendication 8, dans lequel le module de détection de qualité de communication (32) est configuré pour, dans un processus d'initialisation du démarrage de la ligne de RPF ou dans un processus de travail de la ligne de RPF, détecter si les paramètres de qualité de communication de la ligne de RPF dépassent la plage prédéfinie.

11. Dispositif selon la revendication 8, dans lequel le module d'analyse de bruit d'alimentation électrique (34) comprend :
une unité d'évaluation (340), qui est configurée pour évaluer si la ligne de RPF est unique ;
une unité de coupure d'alimentation électrique (344), qui est configurée pour, lorsque l'unité d'évaluation (340) évalue que la ligne de RPF n'est pas l'unique ligne de RPF, couper l'alimentation électrique de la ligne de RPF ;
une unité de détection de qualité de communication (346), qui est configurée pour détecter si les paramètres de qualité de communication de la ligne de RPF dépassent la plage prédéfinie ;
une première unité d'analyse de bruit d'alimentation électrique (347), qui est configurée pour, lorsque la ligne de RPF est dans l'état de coupure d'alimentation électrique et l'unité de détection de qualité de communication (346) détecte que les paramètres de qualité de communication de la ligne de RPF ne dépassent pas la plage prédéfinie, déterminer que la raison amenant les paramètres de qualité de communication de la ligne de RPF à dépasser la plage prédéfinie est le bruit d'alimentation électrique, et lorsque la ligne de RPF est dans l'état de coupure d'alimentation électrique et l'unité de détection de qualité de communication (346) détecte que les paramètres de qualité de communication de la ligne de RPF dépassent la plage prédéfinie, déterminer que la raison amenant les paramètres de qualité de communication de la ligne de RPF à dépasser la plage prédéfinie n'est pas le bruit d'alimentation électrique.

12. Dispositif selon la revendication 11, dans lequel le module d'analyse de bruit d'alimentation électrique (34) comprend en outre :
une deuxième unité d'analyse de bruit d'alimentation électrique (348), qui est configurée pour, lorsque la ligne de RPF est dans l'état de coupure d'alimentation électrique et il est détecté que les paramètres de qualité de communication de la ligne de RPF ne dépassent pas la plage prédéfinie, analyser le résultat de surveillance d'un module de surveillance de bruit d'alimentation électrique d'un côté local et d'un terminal, et déterminer si un diviseur électrique (PS) du côté local ou un PS du terminal présente un problème.

13. Dispositif selon la revendication 11, dans lequel le module d'analyse de bruit d'alimentation électrique (34) comprend en outre :
une troisième unité d'analyse de bruit d'alimentation électrique (342), qui est configurée pour, lorsqu'il est évalué que la ligne de RPF est unique, analyser si le bruit d'alimentation électrique du côté local ou du terminal est anormal, et lorsqu'il est analysé que le bruit d'alimentation électrique du côté local ou du terminal est anormal, déterminer que la raison amenant les paramètres de qualité de communication de la ligne de RPF à dépasser la plage prédéfinie est le bruit d'alimentation électrique.
